# EUROPEAN PATENT APPLICATION

(11) **EP 2 346 093 A2**
(43) Date of publication of application: **20.07.2011**
(21) Application number: 10165119.8
(22) Date of filing: 07.06.2010
(51) Int. Cl.: H01L 31/052, H01L 23/473

(54) **Solar panel heat-dissipating device and related solar panel module**

(30) Priority: 14.01.2010 TW 099100909
(71) Applicant: Axuntek Solar Energy, Pingtung County 900 (TW)
(72) Inventor: Lee, Shih-Wei, 843, Kaohsiung County (TW); Liang, Tien-Hsing, 111, Taipei City (TW); Hou, Chi-Hung, 100, Taipei City (TW); Chiu, Chen-Hai, 308, Hsinchu County (TW); Tseng, Chiu-An, 826, Kaohsiung County (TW)
(74) Representative: Becker Kurig Straus

(57) **Abstract**

A solar panel heat-dissipating device (14) for adjusting temperature of a solar panel (12) includes a base (16) for supporting the solar panel (12), and a cooling plate (18) disposed between the solar panel (12) and the base (16). The cooling plate (18) includes a cooling tube (20) contacting a side of the solar panel (12) so as to absorb heat generated by the solar panel (12). In addition, conductive fluid is accommodated inside the cooling tube (20) for dissipating the heat of the cooling tube (20) conducted from the solar panel (12).

## Description

The present invention relates to a solar panel heat-dissipating device for adjusting temperature of a solar panel and a related solar panel module according to the pre-characterizing clauses of claims 1 and 10.

A solar panel can be disposed on the housetop of the building for transforming solar energy of the sunlight received by the solar panel into electrical energy. When the conventional solar panel tile is under sunlight, the solar panel will continuously transform the solar energy into the electrical energy. However, when the conventional solar panel tile is under long-term sunlight, the temperature of the entire solar panels might rise up to exceed the best working temperature due to continuation of generating electricity. Generally, the best working temperature of the conventional solar panel tile is between 25°C to 55°C , but the working temperature of the conventional solar panel tile will rise up to more than 75 °C under long-term sunlight. At this time, transformation rate of the solar panel for generating electricity will drop fast due to the high temperature of entire solar panels, and electronic components of the solar panel will be damaged by the high temperature easily. Thus, design of a solar panel tile for adjusting the temperature of the solar panel to the best working temperature is an important issue in the solar panel industry.

This in mind, the present invention aims at providing a solar panel heat-dissipating device and a related solar panel module that can adjust temperature of a solar panel to the best working temperature.

This is achieved by providing a solar panel heat-dissipating device for adjusting temperature of a solar panel and a related solar panel module according to claims 1 and 10. The dependent claims pertain to corresponding further developments and improvements.

As will be seen more clearly from the detailed description following below, the claimed solar panel heat-dissipating device includes a base and a cooling plate. The base is utilized for supporting a solar panel. The cooling plate is disposed between the solar panel and the base. A cooling tube is installed on the cooling plate for contacting a side of the solar panel to absorb heat generated by the solar panel. Conductive fluid is accommodated inside the cooling tube for dissipating heat of the cooling tube conducted from the solar panel.

In the following, the invention is further illustrated by way of example, taking reference to the accompanying drawings. Thereof
FIG.1 is an exploded diagram of a solar panel module according to a preferred embodiment of the present invention, and
FIG.2 is a diagram of the solar panel module according to the preferred embodiment of the present invention.

To provide a better understanding of the presented invention, a preferred embodiment will be explained in details. The preferred embodiment of the present invention is illustrated in the accompanying drawings with numbered elements, but application of the present invention is not limited to the preferred embodiment.

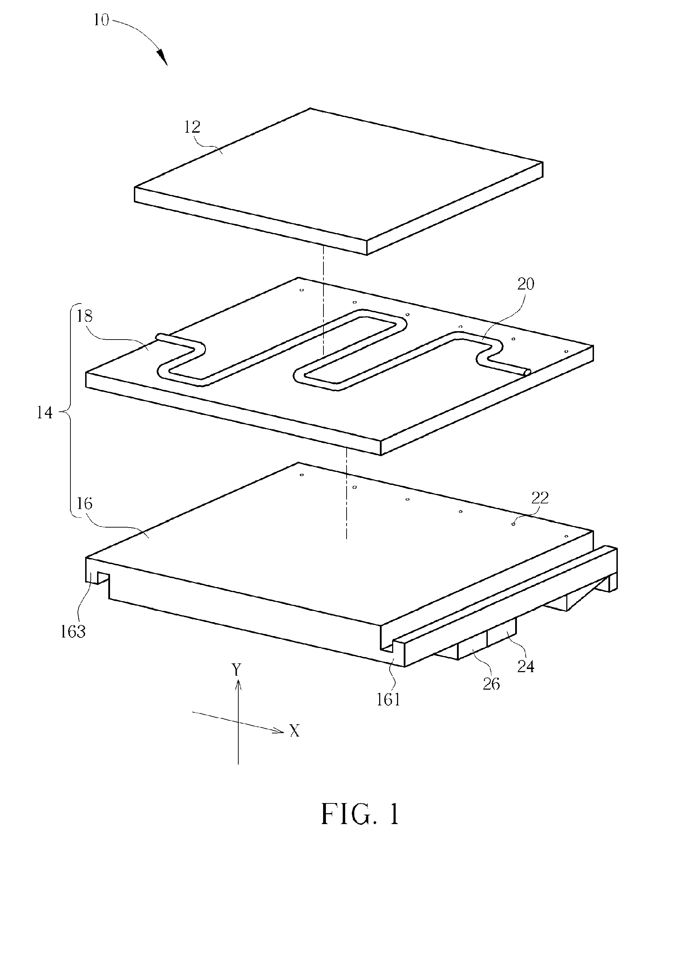

Please refer to FIG. 1. FIG. 1 is an exploded diagram of a solar panel module 10 according to a preferred embodiment of the present invention. The solar panel module 10 includes a solar panel 12 and a solar panel heat-dissipating device 14. The solar panel heat-dissipating device 14 includes a base 16 for supporting the solar panel 12. The solar panel heat-dissipating device 14 further includes a cooling plate 18 disposed between the solar panel 12 and the base 16. The cooling plate 18 is utilized for dissipating heat generated by the solar panel 12 so as to achieve better power generation efficiency of the solar panel 12. A cooling tube 20 is installed on the cooling plate 18 for contacting a side of the solar panel 12, and the cooling tube 20 can be made of metal material with high heat conductivity. Conductive fluid is accommodated inside the cooling tube 20, and the conductive fluid can be water, cooling fluid, or other fluid with high heat conductivity. Two openings are formed on two ends of the cooling tube 20 respectively. Two openings can be disposed on different levels of the cooling plate 18, which means the two openings of the cooling tube 20 can be in different horizontal levels when the solar panel module 10 is utilized as an external cover of the building, such as a tile structure installed on a roof of the building or a brick structure attached on an outer wall of the building. The cooling tube 20 is utilized for absorbing heat generated by the solar panel 12 and for accommodating conductive fluid inside the cooling tube 20 for dissipating heat generated by the solar panel 12. In this preferred embodiment, the cooling tube 20 can be a Z-shaped tubal component, and the tube with the Z-shape provides a larger contacting area of the cooling tube 20 and the solar panel 12. Simultaneously, conductive fluid flows smoothly inside the cooling tube 20 so as to efficiently take heat generated by the solar panel 12 away. The shape of the cooling tube 20 is not limited to the above-mentioned embodiment and depends on design demand.

In addition, a first wedging portion 161 is formed on a first lateral wall of the base 16, and a second wedging portion 163 is formed on a second lateral wall of the base 1 6. The first lateral wall and the second lateral wall can be respectively disposed on two edges of the base 16 in parallel. The first wedging portion 161 and the second wedging portion 163 are capable of wedging tightly with corresponding parts of other solar panel modules along X direction, so that the solar panel module 10 can conveniently connect to other solar panel module as an array. For example, the first wedging portion 161 and the second wedging portion 163 are structural components capable of wedging with each other tightly, thus a user can connect the first wedging portion 1 61 and the second wedging portion 163 of the solar panel module 10 with the corresponding second wedging portion and the corresponding first wedging portion of other solar panel modules along X direction. At least one fixing portion 22 is disposed on the base 16, and the fixing portion 22 is utilized for connecting the solar panel module 10 to other solar panel modules in Y direction substantially perpendicular to X direction, so that a plurality of solar panel modules can be combined as a solar panel module with large size along X direction and Y direction. Thus, the solar panel module 10 can be designed as an external cover of the building, such as a tile structure installed the roof of the building, a brick structure attached on an outer wall of the building, etc. The application of the solar panel module 10 is not limited to the above-mentioned embodiment and depends on design demand.

In addition, the solar panel heat-dissipating device 14 further includes a transmission cable (not shown in figures) and a junction box 24 disposed on a side of the base. Two ends of the transmission cable are electrically connected to the solar panel 12 and the junction box 24 so as to transmit electricity converted by the solar panel 12 to the junction box 24. The solar panel heat-dissipating device 14 further includes a battery module 26 electrically connected to the junction box 24 for storing the electricity received by the junction box 24.

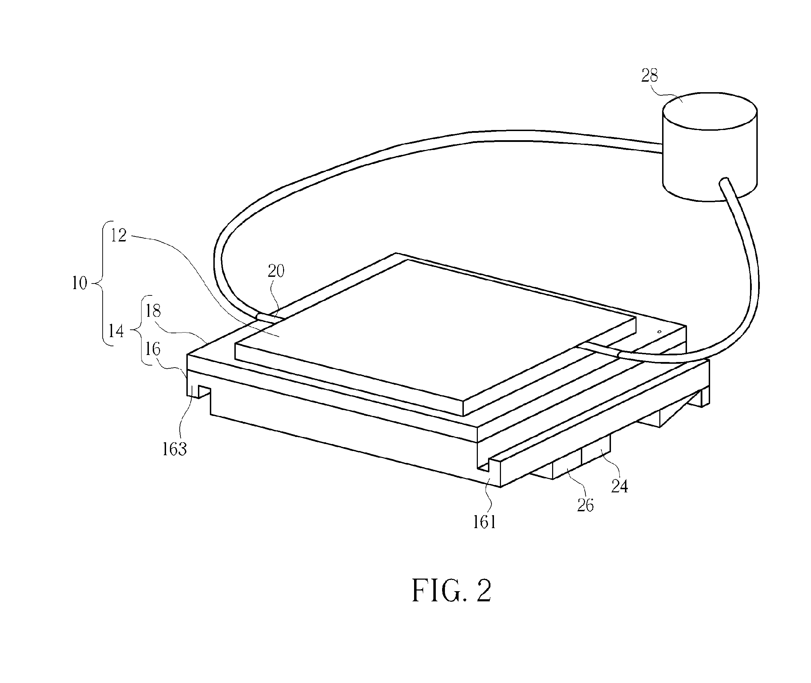

For efficiently dissipating heat generated by the solar panel 1 2, conductive fluid with lower temperature flows into the cooling tube 20 in a lower position. When the cooling tube 20 absorbs heat generated by the solar panel 12, conductive fluid is capable of absorbing heat generated by the solar panel 12 and conducted from the cooling tube 20 and then flows out of the opening of the cooling tube 20 in a high position so as to take heat generated by the solar panel 12 away. Accordingly, the solar panel module 10 of the present invention is a heat exchange circulation system utilizing natural heat exchange. Please refer to FIG. 2. FIG.2 is a diagram of a solar panel module 10 according to a preferred embodiment of the present invention. The solar panel heat-dissipating device 14 as shown in FIG. 2 further includes a container 28 for communicating with the two ends of the cooling tube 20. The solar panel module 10 can guide flowing direction of conductive fluid in the cooling tube 20 by the natural heat exchange, which means that conductive fluid absorbing the heat generated by the solar panel 12 in the cooling tube 20 can automatically flow into the outer container 28 of the solar panel module 10 to be cooled down. At the same time, conductive fluid with lower temperature can flow from the container 28 into the cooling tube 20 so as to circulate the conductive fluid around the container 28 and the cooling tube 20. Conductive fluid will efficiently dissipate the heat generated by the solar panel 1 2 so as to reduce the working temperature of the solar panel 12.

When the users want to use the heat-dissipating device, the container 28 is communicated with the two ends of the cooling tube 20. Then the conductive fluid absorbing the heat generated by the solar panel 12 with high temperature can flow out of the cooling tube 20, and the cooled down conductive fluid with lower temperature can pour into the cooling tube 20 to reabsorb heat generated by the solar panel 12. The conductive fluid circulates around the container 28 and the cooling tube 20 repeatedly for dissipating the heat generated by the solar panel 1 2. Therefore, the solar panel module 10 of the present invention can reduce the working temperature of the solar panel 12 efficiently.

Comparing to the prior art, the solar panel module of the present invention utilizes the heat-dissipating system of fluid circulation for adjusting the working temperature of the solar panel module. The solar panel module of the present invention not only has convenient assembly and low cost but also effectively controls the working temperature of the solar panel module in a range of preferred efficiency for generating electrical power.

## Claims

1. A solar panel heat-dissipating device (14) comprising:
a base (16) for supporting a solar panel (12); and
**characterized in that** the solar panel heat-dissipating device (14) further comprises:
a cooling plate (18) disposed between the solar panel (12) and the base (16), a cooling tube (20) being installed on the cooling plate (18) for contacting a side of the solar panel (12) to absorb heat generated by the solar panel (12), and conductive fluid being accommodated inside the cooling tube (20) for dissipating heat of the cooling tube (20) conducted from the solar panel (12).

2. The solar panel heat-dissipating device (14) of claim 1 , **characterized in that** the cooling tube (20) is a Z-shaped tubal component.

3. The solar panel heat-dissipating device (14) of claims 1 or 2, **characterized in that** two openings are formed on two ends of the cooling tube (20) respectively for flowing in or flowing out the conductive fluid.

4. The solar panel heat-dissipating device (14) of claim 3, **characterized in that** the solar panel heat-dissipating device (14) further comprises:
a container (28) for storing the conductive fluid, the container (28) being communicated with the two ends of the cooling tube (20) to circulate the conductive fluid around the container (28) and the cooling tube (20).

5. The solar panel heat-dissipating device (14) of claims 1 , 2, 3, or 4, **characterized in that** the solar panel heat-dissipating device (14) further comprises:
a junction box (24) disposed on a side of the base (16); and
a transmission cable, two ends of each transmission cable
being electrically connected to the solar panel (12) and the junction box (24) respectively, so as to transmit electricity converted by the solar panel (12) to the junction box (24).

6. The solar panel heat-dissipating device (14) of claim 5, **characterized in that** the solar panel heat-dissipating device (14) further comprises:
a battery module (26) electrically connected to the junction
box (24) for storing the electricity received by the junction box (24).

7. The solar panel heat-dissipating device (14) of claims 1 , 2, 3, 4, 5, or 6, **characterized in that** the cooling tube (20) is made of metal material.

8. The solar panel heat-dissipating device (14) of claims 1 , 2, 3, 4, 5, 6, or 7, **characterized in that** the conductive fluid is water.

9. The solar panel heat-dissipating device (14) of claims 1 , 2, 3, 4, 5, 6, 7, or 8, **characterized in that** the solar panel heat-dissipating device (14) is a tile structure.

10. A solar panel module (10) comprising:
a solar panel (12); and
a solar panel heat-dissipating device (14) comprising:
a base (16) for supporting the solar panel (12); and **characterized in that** the solar panel heat-dissipating
device (14) further comprises:
a cooling plate (1 8) disposed between the solar panel (1 2) and the base (16), a cooling tube (20) being installed on the cooling plate (1 8) for contacting a side of the solar panel (12) to absorb heat generated by the solar panel (12), and conductive fluid being accommodated inside the cooling tube (20) for dissipating heat of the cooling tube (20) conducted from the solar panel (12).

11. The solar panel module (10) of claim 10, **characterized in that** the cooling tube (20) is a Z-shaped tubal component.

12. The solar panel module (10) of claims 1 0 or 11, **characterized in that** two openings are formed on two ends of the cooling tube (20) respectively for flowing in or flowing out the conductive fluid.

13. The solar panel module (10) of claim 12, **characterized in that** the solar panel heat-dissipating device (14) further comprises a container (28) for storing the conductive fluid, the container (28) being communicated with the two ends of the cooling tube (20) to circulate the conductive fluid around the container (28) and the cooling tube (20).

14. The solar panel module (10) of claims 10, 1 1 , 12, or 13, **characterized in that** a first wedging portion (161) is formed on a first lateral wall of the base (16), a second wedging portion (163) is formed on a second lateral wall of the base (16), and the first wedging portion (161) and the second wedging portion (163) are structural components capable of wedging with each other tightly.

15. The solar panel module (10) of claim 14, **characterized in that** the first lateral wall and the second lateral wall are respectively disposed on two edges of the base (16) in parallel.
